# EUROPEAN PATENT APPLICATION

(11) **EP 1 655 613 A2**
(43) Date of publication of application: **10.05.2006**
(21) Application number: 05024218.9
(22) Date of filing: 07.11.2005
(51) Int. Cl.: G01R 15/20, G01R 33/038

(54) **Low power and proximity AC current sensor**

(30) Priority: 09.11.2004 KR 2004091066; 09.12.2004 KR 2004103821
(71) Applicant: LG Electronics Inc., Yongdungpo-gu Seoul (KR)
(72) Inventor: Bu, Jong-Uk, No. 804-101, Seongnam-si, Gyeonggi-do 463-010 (KR); Kim, Seong-Hyok, No. 101-204, Eunpyeong-gu, Seoul 122-051 (KR); Choi, Jung-Hoon, No. 325-1001 Sangnokmaeul, Seongnam-si, Gyeonggi-do 463-010 (KR); Yee, Young-Joo, No. 701-1301 Tapmaeul, Seongnam-si, Gyonggi-do 463-923 (KR)
(74) Representative: von Hellfeld, Axel

(57) **Abstract**

Disclosed herein is a low-power proximity AC current sensor. A low-power proximity AC current sensor according to the present invention includes a magnetic material (21) having a location that changes depending on the intensity of a magnetic field formed outside the magnetic material; a piezoelectric film (22) disposed at a location adjacent to the magnetic material and configured to generate electric charge due to a change in location of the magnetic material; and a substrate (25) for securing the piezoelectric film. Another low-power proximity AC current sensor according to the present invention includes a magnetic material (71) having a location that changes depending on the intensity of a magnetic field formed outside the magnetic material; corresponding electrodes (72,73) disposed at a location adjacent to the magnetic material and configured to vary capacitance depending on a change in location of the magnetic material; and a substrate (77) for securing the lower electrode (73).

## Description

### BACKGROUND OF THE INVENTION

### 1. Field of the Invention

The document relates to a low-power proximity Alternating Current (AC) current sensor.

### 2. Description of the Related Art

In general, AC current sensors are classified into ampere meter-type sensors that detect current using electromagnetic force generated between current flowing through a coil and a magnet, hall sensors that use the Hall effect, and Great Magneto-Resistance (GMR)-type current sensors that detect variation in magneto-resistance.

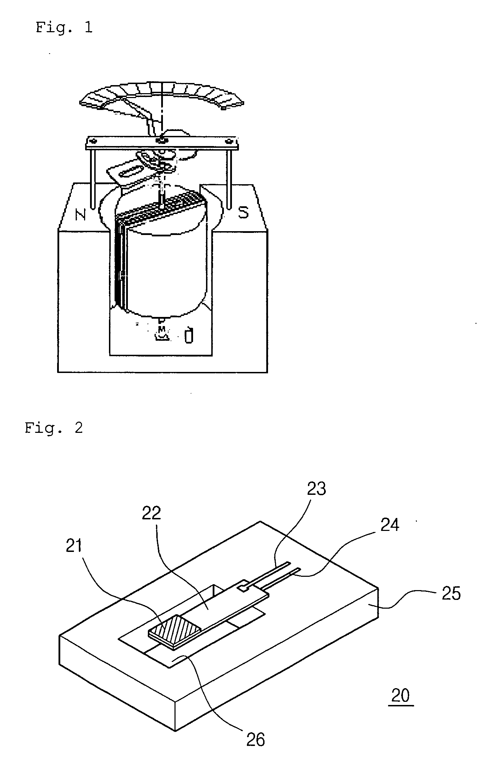

FIG. 1 is a schematic diagram illustrating the construction of a typical ampere meter and the arrangement of the components thereof. The ampere meter is generally connected in series to a conducting line through which current flows, and measures the amount of current in the conducting line using the electromagnetic force that is generated between a magnetic field generated by current flowing through a movable coil wound on a soft iron core, and a permanent magnet mounted in the ampere meter.

However, the ampere meter-type current sensors are difficult to install because they are directly connected to conducting lines through which current flows, and are disadvantageous in that they have many movable components and are large, thus being expensive. Meanwhile, the hall sensors and the GMR-type current sensors have advantages in size and ease of installation over the ampere meter-type current sensors, but are disadvantageous in that power is consumed because power is supplied to the sensors and the sensors are operated using the power. These types of sensors are unsuitable for use in sensor networks because of their size, price and power consumption.

### SUMMARY OF THE INVENTION

Accordingly, the present invention has been made keeping in mind the above problems occurring in the prior art, and an object of the present invention is to provide a low-power proximity AC current sensor that measures the amount of AC current flowing through a conducting line using electromagnetic force that is applied to a magnetic material, which is attached to the sensor, by a magnetic field induced by the current flowing through the conducting line.

In order to accomplish the above object, the present invention provides a low-power proximity AC current sensor, including a magnetic material having a location that changes depending on the intensity of a magnetic field formed outside the magnetic material; a piezoelectric film disposed at a location adjacent to the magnetic material and configured to generate electric charge due to a change in location of the magnetic material; and a substrate for securing the piezoelectric film.

Furthermore, the present invention provides a low-power proximity AC current sensor, including a magnetic material having a location that changes depending on the intensity of a magnetic field formed outside the magnetic material; corresponding electrodes disposed at a location adjacent to the magnetic material and configured to vary capacitance depending on a change in location of the magnetic material; and a substrate for securing the piezoelectric film.

In order to implement a low-power sensor, the present invention uses a method of detecting a piezoelectric effect varying depending on current and a method of detecting variation in capacitance. Furthermore, the present invention provides a low-power proximity AC current sensor that can detect the amount of current only by causing the sensor to approach a conducting line through which the current flows, without an electrical connection, unlike an existing current sensor that is connected to the interior of an electrical circuit formed by a conducting line for which the amount of current is detected.

The low-power proximity AC current sensor according to the present invention basically includes a cantilever, a bridge, a membrane movable structure, and a magnetic material and a sensing part provided in the movable structure. The magnetic material of the proximity current sensor according to the present invention is subjected to force due to an induced magnetic field generated by AC current around the conducting line, therefore the movable structure is moved, thus resulting in the deformation and displacement thereof. Such deformation or displacement is detected using a piezoelectric effect or variation in capacitance.

In particular, the AC current sensor according to the present invention can detect current only by being attached to a predetermined location, such as a covering part, that is adjacent to the conducting line through which the AC current flows. Since the piezoelectric effect and variation in capacitance are generated due to the movement of the movable structure, power consumption can be considerably reduced.

### BRIEF DESCRIPTION OF THE DRAWINGS

The above and other objects, features and advantages of the present invention will be more clearly understood from the following detailed description taken in conjunction with the accompanying drawings, in which:
FIG. 1 is a perspective view illustrating the internal structure of a typical ampere meter;
FIG. 2 is a perspective view of a low-power proximity AC current sensor according to an embodiment of the present invention;
FIGS. 3A to 3F are perspective views showing various examples of low-power proximity AC current sensors according to embodiments of the present invention;
FIG. 4 is a perspective view showing an example of the mounting of the low-power proximity AC current sensor according to the embodiment of the present invention;
FIG. 5 is a conceptual view illustrating the operational principle of the low-power proximity AC current sensor according to the embodiment of the present invention;
FIGS. 6A and 6B are perspective views of a low-power proximity AC current sensor having an additional external noise removal function according to an embodiment of the present invention;
FIG. 7 is a perspective view of a capacitance detection-type low-power proximity AC current sensor according to an embodiment of the present invention;
FIGS. 8A to 8F show various examples of the capacitance detection-type low-power proximity AC current sensor according to an embodiment of the present invention;
FIG. 9 shows an example the mounting of the capacitance detection-type low-power proximity AC current sensor according to the embodiment of the present invention;
FIG. 10 is a conceptual view illustrating the operating principle of the capacitance detection-type low-power proximity AC current sensor according to an embodiment of the present invention; and
FIGS. 11A and 11B are perspective views of a capacitance detection-type low-power proximity AC current sensor having an external noise removal function according to an embodiment of the present invention.

### DESCRIPTION OF THE PREFERRED EMBODIMENTS

Preferred embodiments of the present invention will be described in detail below with reference to the accompanying drawings. Reference now should be made to the drawings, in which the same reference numerals are used throughout the different drawings to designate the same or similar components.

FIG. 2 is a perspective view of a low-power proximity AC current sensor 20 according to an embodiment of the present invention.

In this embodiment, the low-power proximity AC current sensor 20 includes a magnetic material 21, a piezoelectric thin film 22, an upper plate wire 23, a lower plate wire 24 and a substrate 25.

In FIG. 2, a structure in which the low power AC current sensor 20 is formed of the piezoelectric film 22 is schematically illustrated.

Referring to FIG. 2, a depression 26 is formed in the substrate 25 at a location that is slightly biased from the center thereof to one side. The piezoelectric film 22 is formed over the depression 26. The location of the depression 26 is not limited to the one described above, but can be any location on the substrate 25 as long as the piezoelectric film 22 is allowed to move freely.

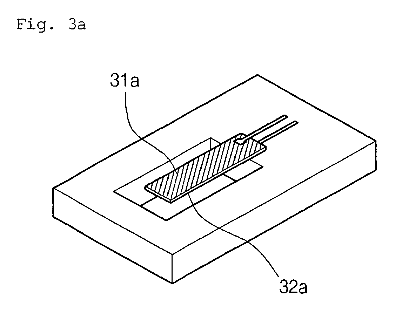

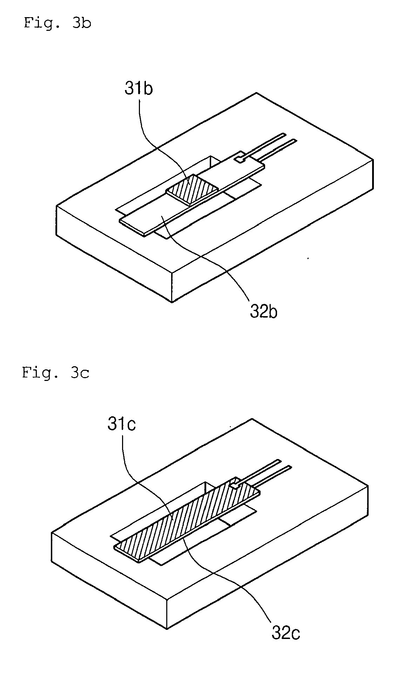

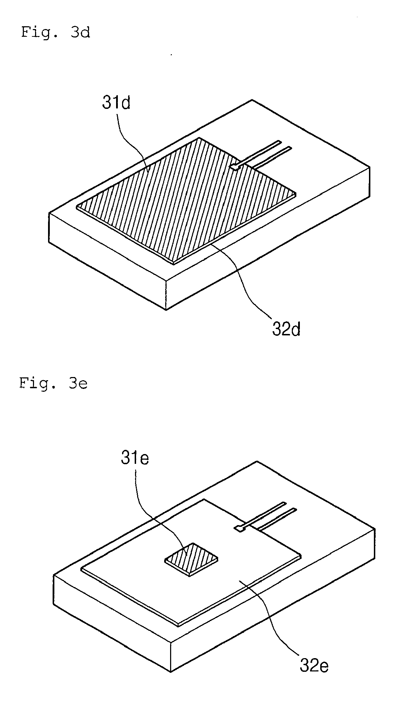

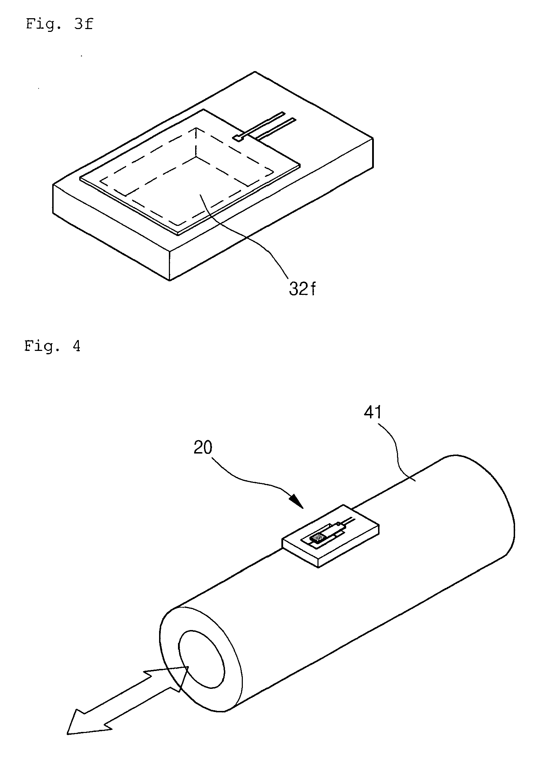

The magnetic material 21 is layered on the piezoelectric film 22. A pair of electrode wires 23 and 24 is formed at one side of the piezoelectric film 22. The upper plate wire 23 is brought into contact with the upper surface of the piezoelectric film 22, while the lower plate wire 24 is connected to the lower surface of the piezoelectric film 22. In the above-described embodiment, the piezoelectric film 22 has a cantilever shape. The piezoelectric film 22 may have various shapes. A method of forming the piezoelectric film 22 will be described in detail below with reference to FIG. 3.

The piezoelectric film 22 generates electric charge by the deformation thereof. It is preferred that Rochelle salt or barium titanate, having a high piezoelectric effect, be used as the material of the piezoelectric film 22.

The piezoelectric film 22 is deformed by the movement of the magnetic material 21. If a magnetic field is formed around the piezoelectric film 22 and the magnetic material 21 formed on the piezoelectric film 22 moves, the piezoelectric film 22 is deformed accordingly. The change in location of the magnetic material is proportional to the magnitude of the surrounding magnetic field.

The electrode wires 23 and 24 function to guide the electric charge, which is generated in the piezoelectric film 22, to a predetermined measuring device (not shown) in order to measure the amount of charge generated in the piezoelectric film 22.

In summary, when AC current is formed in a typical conducting line, a magnetic field is formed around the conducting line in proportion to the amount of current, the location of the magnetic material 21 changes in proportion to the magnitude of the magnetic field, and the amount of electric charge formed in the piezoelectric film 22 changes depending on the change in location of the magnetic material 21, so that the amount of current can be measured.

FIGS. 3A to 3F show various examples of a low-power proximity AC current sensor according to embodiments of the present invention.

FIG. 3A shows a cantilever-shaped low-power proximity AC current sensor in which a magnetic material 31a is deposited on the entire surface of a piezoelectric film 32b. FIG. 3B shows a bridge-shaped low-power proximity AC current sensor in which a magnetic material 31b is deposited on part of a piezoelectric film 32b. FIG. 3C shows a bridge-shaped low-power proximity AC current sensor in which a magnetic material 31c is deposited on the entire surface of a piezoelectric film 32c. FIG. 3D shows a thin film-type low-power proximity AC current sensor in which a magnetic material 31d is deposited on the entire surface of a piezoelectric film 32d. FIG. 3E shows a thin film-type low-power proximity AC current sensor in which a magnetic material 31e is deposited on part of a piezoelectric film 32e. FIG. 3F shows an AC sensor from which the magnetic material of the thin film type AC sensor shown in FIG. 3D or 3E is removed. It is preferred that a depression 32f formed in the substrate of the AC sensor having the thin film shape be larger than those formed in the AC sensors having the cantilever and bridge shapes.

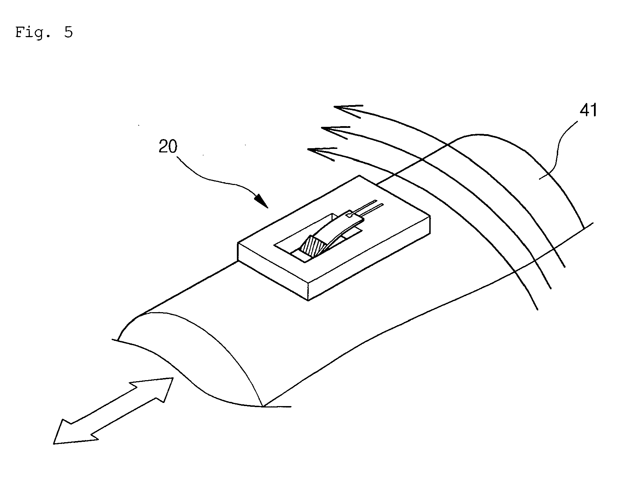

FIG. 4 shows an example of the mounting of the low-power proximity AC current sensor according to the embodiment of the present invention. FIG. 5 is a conceptual view illustrating the operational principle of a low-power proximity AC current sensor 20 according to the embodiment of the present invention.

Referring to FIG. 5, a concentric circle-shaped magnetic field is generated around a conducting line 41 due to current flowing through the conducting line 41. The low-power current sensor 20, including a piezoelectric film to which a magnetic material is attached, is moved by the magnetic field. As shown in FIG. 5, in the case of the piezoelectric film made of a piezoelectric material, an electric charge is generated by the movement of the piezoelectric film, the voltage or current of which can be measured.

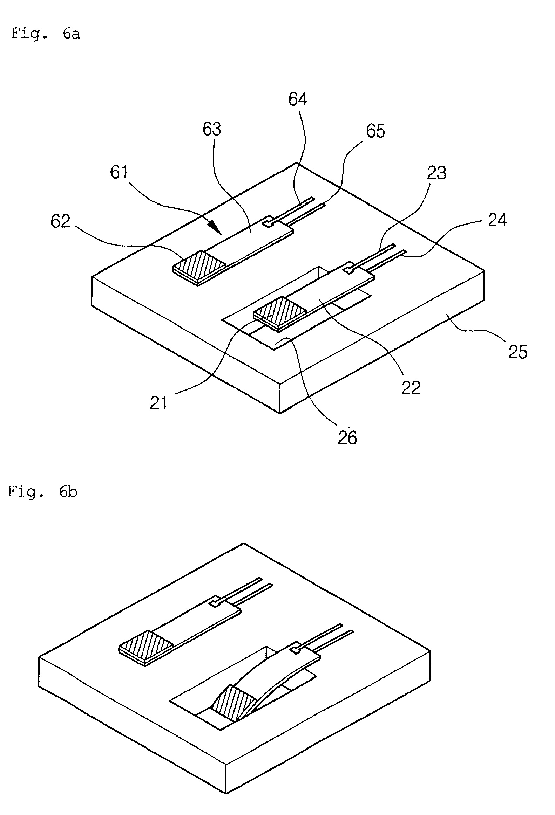

FIGS. 6A and 6B are perspective views of a low-power proximity AC current sensor package having an additional external noise removal function according to an embodiment of the present invention.

In this embodiment, in the low-power proximity AC current sensor package, a reference sensor 61 is further included in the low-power proximity AC current sensor 20 shown in FIG. 2.

In FIGS. 6A and 6B, the shape of the reference sensor 61 is schematically illustrated.

Referring to FIG. 6A, the reference sensor 61 has the same construction as the current sensor shown in FIG. 2 except that a depression is not formed in the portion of a substrate 25 where the reference sensor 61 is formed. In general, noise components as well as a signal generated from current always exist around a conducting line through which the current flows. In order to remove the external noise components, the reference sensor 61 may additionally be used. For the same current input, the reference sensor 61 generates only noise components in which the movement of a corresponding electrode is not included. Therefore, when the two signals are subtracted from each other, a pure signal generated by the current can be detected.

The method of measuring current depending on variation in the amount of charge, which is generated in the piezoelectric film depending on variation in a surrounding magnetic field, has been described above. A sensor for measuring current by measuring variation in capacitance, not by using the piezoelectric effect, will be described below.

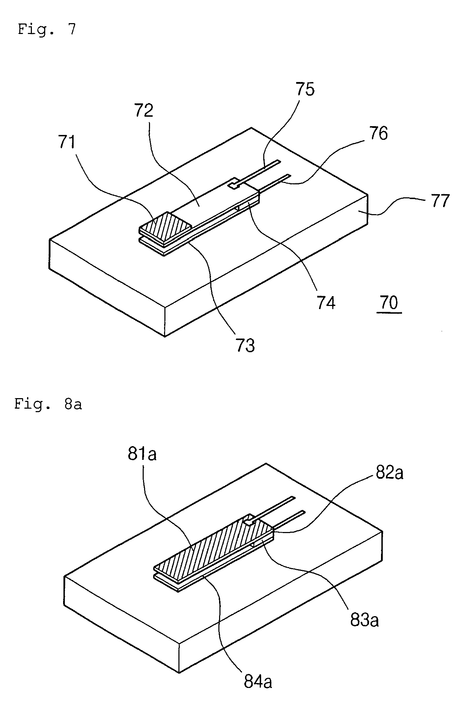

FIG. 7 is a perspective view of a capacitance detection-type low-power proximity AC current sensor according to an embodiment of the present invention.

In the above embodiment, the low-power proximity AC current sensor includes a magnetic material 71, corresponding electrodes 72 and 73, a support 74, electrode wires 75 and 76, and a substrate 77.

In FIG. 7, a structure in which the corresponding electrodes 72 and 73 are formed on the substrate 77 is schematically illustrated.

Referring to FIG. 7, the corresponding electrodes 72 and 73 are formed on the top of the substrate 77. The magnetic material 71 is layered on the top of the corresponding electrodes 72. The corresponding electrodes 72 and 73 are formed such that the upper plate 72 and the lower plate 73 face each other and have a predetermined gap therebetween. It is preferred that the predetermined gap between the upper plate 72 and the lower plate 73 be achieved by layering the support 74 having a predetermined thickness on one side of the lower plate 73 and layering the upper plate 72 on the support 74.

The electrode wires 75 and 76 are brought into contact with first sides of the upper plate 72 and the lower plate 73 that are in contact with the support 74. It is preferred that the upper plate wire 75 be connected to the upper surface of a first side of the upper plate 72 and the lower plate wire 76 be connected to the lower surface of a first side of the lower plate 73. In this embodiment, the current sensor may be formed in a cantilever shape. The corresponding electrodes 72 and 73 may be formed in various shapes. A method of forming corresponding electrodes will be described in detail below with reference to FIG. 8.

The upper plate 72 is deformed by the movement of the magnetic material 71. When the magnetic material 71 formed on the upper plate 72 is moved by a magnetic field formed around the upper plate 72, the upper plate 72 is deformed. The location of the magnetic material 71 changes in proportion to the magnitude of a surrounding magnetic field. As the upper plate 72 is deformed, the distance between the upper plate 72 and the lower plate 73 varies. This variation changes the capacitance between the two electrodes 72 and 73. Therefore, the capacitance changes in proportion to the amount of the magnetic field formed around the conducting line, so that the magnitude of a magnetic field can be easily measured.

The electrode wires 75 and 76 function to guide the electric charge, which is formed by the upper and lower plates 72 and 73, to a predetermined measuring device (not shown) in order to measure an electrical signal depending on the capacitance formed between the corresponding electrodes 72 and 73.

In summary, when AC current is formed in a typical conducting line, a magnetic field is formed around the conducting line in proportion to the amount of the current, the location of the magnetic material 71 changes in proportion to the magnetic field, the upper plate 72 of the corresponding electrodes is deformed depending on the change in location of the magnetic material 71, and the distance between the upper plate 72 and the lower plate 73 of the current sensor varies depending on the change. Therefore, the amount of capacitance formed by the upper plate 72 and the lower plate 73 varies, so that the amount of current can be measured.

FIGS. 8A to 8F show various examples of a capacitance detection-type low-power proximity AC current sensor according to an embodiment of the present invention.

FIG. 8A shows a cantilever-shaped capacitance detection-type low-power proximity AC current sensor in which a magnetic material 81a is formed on the entire upper surface of an upper plate 82a. The structure of this embodiment is almost the same as that shown in FIG. 7. However, the magnetic material provided in the capacitance detection-type low-power proximity AC current sensor shown in FIG. 7 is layered on part of the upper plate, whereas the magnetic material in this embodiment is layered on the entire surface of the upper plate 82a. The sensor has a support 83a disposed between the first sides of the corresponding electrodes 82a and 84a, thus forming a gap.

FIG. 8B shows a capacitance detection-type low-power proximity AC current sensor in which a magnetic material 81b is formed on part of an upper plate 82b. The structure of this embodiment is the same as that shown in FIG. 7 except that the magnetic material 81b is layered at the center of the upper plate 82b, but not on one side of the upper plate 82b. In addition, supports 83b are formed not only on first sides of the corresponding electrodes 82a and 84a but also on second sides thereof. Therefore, a gap is formed between the upper and lower plates 82b and 84b by the supports 83b. In the present embodiment, the distance between the central portions of the corresponding electrodes 82b and 84b varies depending on variation in an external magnetic field, thus resulting in variation in capacitance.

FIG. 8C shows a capacitance detection-type low-power proximity AC current sensor in which a magnetic material 81c is formed on the entire surface of the upper plate 82c of the current sensor. The structure of the present embodiment is the same as that of FIG. 8B except that the magnetic material 81c is formed on the entire surface of the upper plate 82c. The sensor also has supports 83c formed on both sides of corresponding electrodes 82c and 84c.

FIG. 8D shows a thin film-shaped capacitance detection-type low-power proximity AC current sensor in which a magnetic material is formed on the entire upper surface of the current sensor. The structure of the present embodiment is the same as that of FIG. 8C except that the shapes of corresponding electrodes 82d and 84d have thin film shapes that extend over the entire substrate of the sensor.

FIG. 8E shows a thin film-shaped capacitance detection-type low-power proximity AC current sensor in which a magnetic material is formed on part of the upper surface of a corresponding electrode. The structure of the present embodiment is almost the same as that of FIG. 8d except that a magnetic material 81e layered on the upper surface of an upper plate 82e is formed at the center portion of the current sensor.

FIG. 8F is a sectional view of the low-power proximity sensor shown in FIG. 8E. A gap is also formed between corresponding electrodes 82e and 84e.

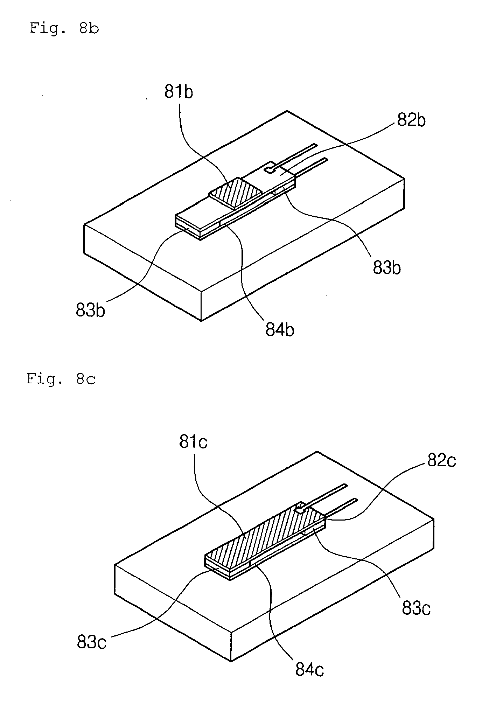

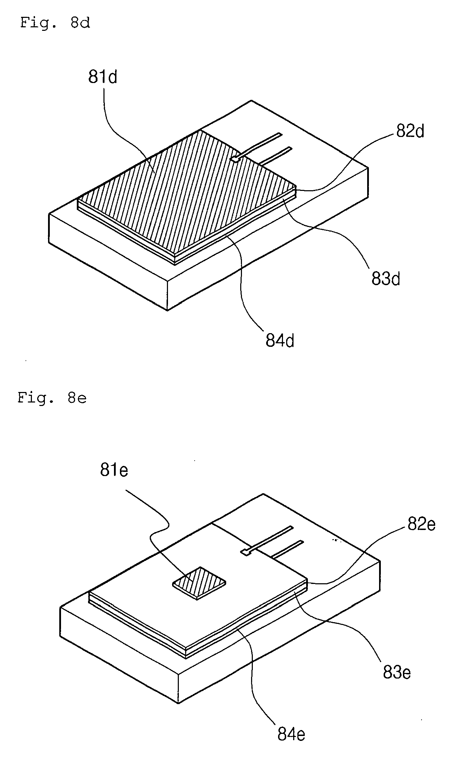

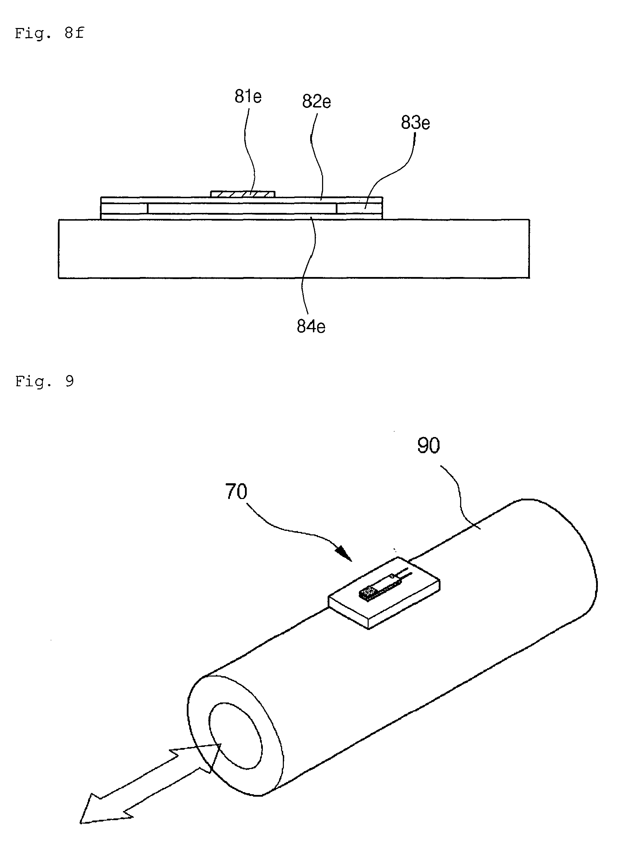

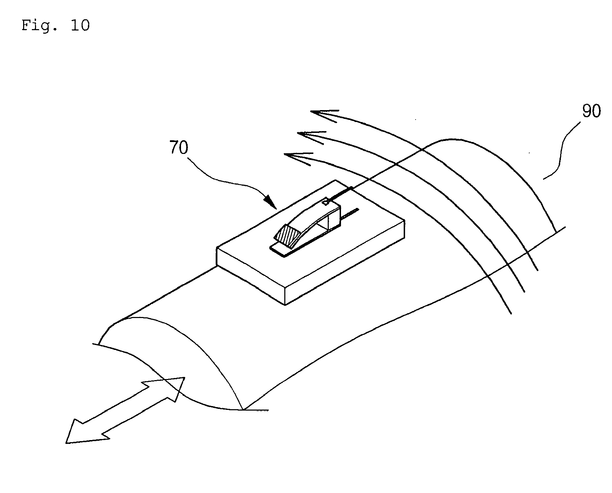

FIGS. 9 and 10 show a state where the capacitance detection-type low-power proximity AC current sensor 70 according to the embodiment of the present invention is attached to a conducting line 90.

Referring to FIG. 9, the capacitance detection-type low-power proximity AC current sensor 70 operates at a location that is adjacent to the conducting line 90. The operation of the sensor 70 will be described with reference to FIG. 10. A concentric circle-shaped magnetic field is generated around the conducting line 90 due to current flowing through the conducting line 90, and an upper plate to which a magnetic material is attached is moved by the magnetic field. As shown in FIG. 10, the capacitance type low-power proximity AC current sensor 70, including the corresponding electrode to which the magnetic material is attached, has varying capacitance depending on the movement of the upper plate, and, thus, can detect the varying capacitance as an electrical signal.

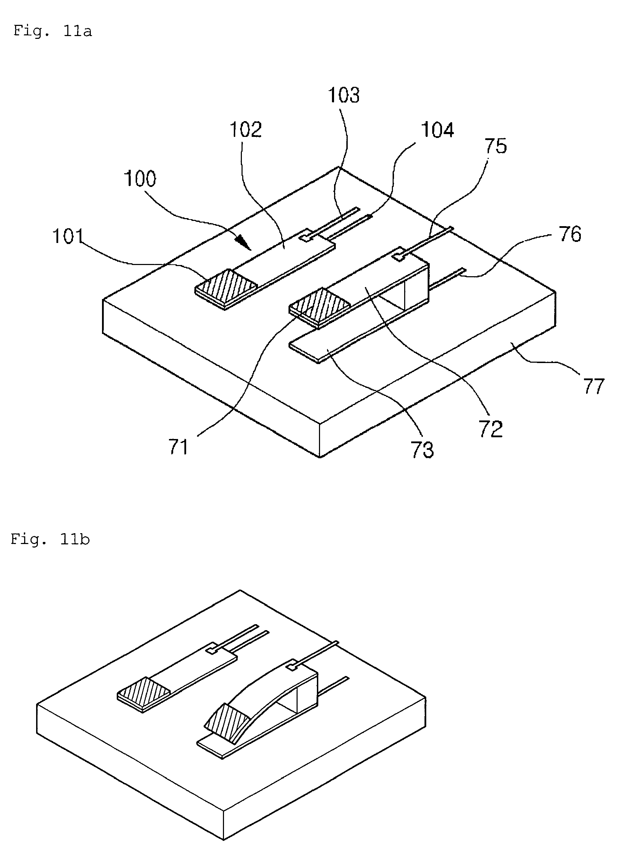

FIGS. 11A and 11B are perspective views of a capacitance detection-type low-power proximity AC current sensor having an external noise removal function according to an embodiment of the present invention.

In the present embodiment, the low-power proximity AC current sensor further includes a reference sensor 100.

Referring to FIGS. 11A and 11B, the reference sensor 100 includes a single electrode 102, and a magnetic material 101 is layered on the upper surface of the electrode 102. It is preferred that the plate 102 of the reference sensor be the same as an upper plate 74 and the magnetic material 101 of the reference sensor 100 be the same as the magnetic material 71 of a current sensor. Noise components as well as a signal generated from current always exist around a conducting line through which the current flows. In order to remove the external noise components, the reference sensor 100 may be additionally provided. For the same current input, the reference sensor 61 generates only noise components from which the influence of the movement of corresponding electrodes 72 and 73 is excluded. Therefore, when the two signals are subtracted from each other, a pure signal generated by the current can be detected.

As described above, in accordance with the present invention, the low-power proximity current sensor of the present invention, which can be fabricated using micro-machine technology and a semiconductor process, can be integrated with a semiconductor circuit, thus implementing an integrated micro-miniature proximity current sensor.

Furthermore, the AC current sensor employs a method of detecting variation in capacitance, so that the AC current sensor has low power consumption and can be used for applications that require low power and micro-sized sensors, such as a sensor network.

In addition, the AC current sensor can measure current simply by being mounted on a conducting line through which the current flows, so that it has an advantage in that the installation thereof is easier than that of existing current sensors.

Although the preferred embodiments of the present invention have been disclosed for illustrative purposes, those skilled in the art will appreciate that various modifications, additions and substitutions are possible, without departing from the scope and spirit of the invention as disclosed in the accompanying claims.

## Claims

1. A low-power proximity Alternating Current (AC) current sensor, comprising:
a magnetic material having a location that changes depending on intensity of a magnetic field formed outside the magnetic material;
a piezoelectric film disposed at a location adjacent to the magnetic material and configured to generate electric charge due to a change in location of the magnetic material; and
a substrate for securing the piezoelectric film.

2. The low-power proximity AC current sensor as set forth in claim 1, further comprising electrode wires for detecting electric charge generated in the piezoelectric film, the electrode wires being connected to a first side of the piezoelectric film.

3. The low-power proximity AC current sensor as set forth in claim 1, further comprising a reference sensor for measuring external noise, the reference sensor being secured to the substrate.

4. The low-power proximity AC current sensor as set forth in claim 1, wherein the substrate is provided with a depression that allows the piezoelectric film to move easily.

5. The low-power proximity AC current sensor as set forth in claim 1, wherein the magnetic material is layered on an entire surface of the piezoelectric film.

6. The low-power proximity AC current sensor as set forth in claim 5, wherein the piezoelectric film is formed on an upper surface of the substrate in a cantilever shape.

7. The low-power proximity AC current sensor as set forth in claim 5, wherein the piezoelectric film is formed on an upper surface of the substrate in a bridge shape.

8. The low-power proximity AC current sensor as set forth in claim 5, wherein the piezoelectric film is formed on an upper surface of the substrate in a thin film shape.

9. The low-power proximity AC current sensor as set forth in claim 1, wherein the magnetic material is layered on part of the piezoelectric film.

10. The low-power proximity AC current sensor as set forth in claim 9, wherein the piezoelectric film is formed on an upper surface the substrate in a cantilever shape.

11. The low-power proximity AC current sensor as set forth in claim 9, wherein the piezoelectric film is formed on an upper surface of the substrate in a bridge shape.

12. The low-power proximity AC current sensor as set forth in claim 9, wherein the piezoelectric film is formed on an upper surface of the substrate in a thin film shape.

13. The low-power proximity AC current sensor as set forth in claim 1, wherein the magnetic material includes at least one selected from a group consisting of iron, nickel and cobalt.

14. The low-power proximity AC current sensor as set forth in claim 1, wherein the AC sensor is disposed at a location adjacent to part of a conducting line.

15. A low-power proximity AC current sensor, comprising:
a magnetic material having a location that changes depending on intensity of a magnetic field formed outside the magnetic material;
corresponding electrodes disposed at a location adjacent to the magnetic material and configured to vary capacitance depending on a change in location of the magnetic material; and
a substrate for securing the piezoelectric film.

16. The low-power proximity AC current sensor as set forth in claim 15, wherein the corresponding electrodes comprise an upper plate and a lower plate, the upper and lower plates being disposed so as to form a predetermined gap therebetween.

17. The low-power proximity AC current sensor as set forth in claim 16, wherein the predetermined gap is formed between the upper plate and the lower plate by a support.

18. The low-power proximity AC current sensor as set forth in claim 15, wherein the corresponding electrodes are provided with electrode wires for detecting capacitance between the corresponding electrodes.

19. The low-power proximity AC current sensor as set forth in claim 15, wherein the substrate is provided with a reference sensor for measuring external noise.

20. The low-power proximity AC current sensor as set forth in claim 16, wherein the magnetic material is layered on an entire upper surface of the upper plate of the corresponding electrodes.

21. The low-power proximity AC current sensor as set forth in claim 20, wherein the corresponding electrodes are formed on an upper surface of the substrate in a cantilever shape.

22. The low-power proximity AC current sensor as set forth in claim 21, wherein the upper and lower plates of the corresponding electrodes are provided with a support only on first sides of the upper and lower plates.

23. The low-power proximity AC current sensor as set forth in claim 21, wherein the upper and lower plates of the corresponding electrodes are provided with supports on both sides of the upper and lower plates.

24. The low-power proximity AC current sensor as set forth in claim 20, wherein the corresponding electrodes are formed on an upper surface of the substrate in a thin film shape.

25. The low-power proximity AC current sensor as set forth in claim 24, wherein the upper and lower plates of the corresponding electrodes are provided with supports on both sides of the upper and lower plates.

26. The low-power proximity AC current sensor as set forth in claim 16, wherein the magnetic material is layered on part of an upper surface of the upper plate of the corresponding electrode.

27. The low-power proximity AC current sensor as set forth in claim 26, wherein the corresponding electrodes are formed on an upper surface of the substrate in a cantilever shape.

28. The low-power proximity AC current sensor as set forth in claim 27, wherein the upper and lower plates of the corresponding electrodes are provided with supports on both sides thereof.

29. The low-power proximity AC current sensor as set forth in claim 26, wherein the corresponding electrodes are formed on an upper surface of the substrate in a thin film shape.

30. The low-power proximity AC current sensor as set forth in claim 29, wherein the upper and lower plates of the corresponding electrodes are provided with supports on both sides thereof.

31. The low-power proximity AC current sensor as set forth in claim 15, wherein the magnetic material comprises at least one selected from a group consisting of iron, nickel and cobalt.

32. The low-power proximity AC current sensor as set forth in claim 15, wherein the AC sensor is installed at a location adjacent to part of a conducting line.
